# EUROPEAN PATENT SPECIFICATION

(11) **EP 2 622 627 B1**
(45) Date of publication and mention of the grant of the patent: **05.09.2018**
(21) Application number: 11740620.7
(22) Date of filing: 22.07.2011
(51) Int. Cl.: H01J 37/34, C23C 14/35

(54) **SYSTEMS AND METHODS FOR FORMING A LAYER OF SPUTTERED MATERIAL**
SYSTEME UND VERFAHREN ZUR HERSTELLUNG EINER SCHICHT AUS SPUTTERMATERIAL
SYSTÈMES ET PROCÉDÉS POUR FORMER UNE COUCHE DE MATÉRIAU PULVÉRISÉ

(30) Priority: 30.09.2010 EP 10184028
(43) Date of publication of application: 07.08.2013
(73) Proprietor: Applied Materials, Inc., Santa Clara, CA 95054 (US)
(72) Inventor: BENDER, Marcus, 63454 Hanau (DE); HANIKA, Markus, 86899 Landsberg (DE); SCHEER, Evelyn, 63811 Stockstadt (DE); PIERALISI, Fabio, 63739 Aschaffenburg (DE); MAHNKE, Guido, 63814 Mainaschaff (DE); LINDENBERG, Ralph, 63654 Büdingen - Rinderbügen (DE); LOPP, Andreas, 63579 Freigericht (DE); SCHWANITZ, Konrad, 63743 Aschaffenburg (DE); LIU, Jian, 63538 Großkrotzenburg (DE)
(74) Representative: Zimmermann & Partner Patentanwälte mbB
(86) International application number: PCT/EP2011/062674
(87) International publication number: WO 2012/041557

(56) References cited:
- EP-A1- 2 090 673
- WO-A1-2008/108185
- WO-A1-2010/090197
- JP-A- 6 081 145
- JP-A- 62 070 568
- JP-A- 63 162 862
- US-A1- 2007 114 122
- US-A1- 2009 178 919
- US-B1- 6 416 635

## Description

### TECHNICAL FIELD

Embodiments of the present disclosure relate to systems and methods for coating a layer on a substrate, and more particularly to methods and systems for forming a layer of sputtered material on a substrate. More specifically, at least some aspects of the present disclosure are related to magnetron sputtering, wherein the target may be for example, but not limited to, a rotatable cylindrical target or a planar target. Even more specifically, some aspects of the present disclosure are related to static sputtering deposition. At least some aspects of the present disclosure particularly relate to substrate coating technology solutions involving equipment, processes and materials used in the deposition, patterning, and treatment of substrates and coatings, with representative examples including, but not limited to, applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

### BACKGROUND ART

Forming a layer on a substrate with a high uniformity (i.e., uniform thickness over an extended surface) is an important issue in many technological fields. For example, in the field of thin film transistors (TFTs) thickness uniformity may be the key for reliably manufacturing display metal lines. Furthermore, a uniform layer typically facilitates manufacturing reproducibility.

One method for forming a layer on a substrate is sputtering, which has developed as a valuable method in diverse manufacturing fields, for example in the fabrication of TFTs. During sputtering, atoms are ejected from the target material by bombardment thereof with energetic particles (e.g., energized ions of an inert or reactive gas). Thereby, the ejected atoms may deposit on the substrate, so that a layer of sputtered material can be formed.

However, forming a layer by sputtering may compromise high uniformity requirements due to, for example, the geometry of the target and/or the substrate. In particular, uniform layers of sputtered material over extensive substrates may be difficult to achieve due to an irregular spatial distribution of sputtered material. The provision of multiple targets over the substrate may improve layer uniformity. Another option is to rotate the magnet of a magnetron sputter cathode with a constant angular velocity in between certain outer positions and around a zero-position. However, in particular for some applications posing high requirements on layer uniformity, the layer uniformity thereby achieved may not be sufficient.

Therefore, further methods and/or systems for facilitating a highly uniform layer of sputtered material are desired.

Document WO 2008/108185 A1 describes a sputtering apparatus with a plurality of stationary targets which are equidistantly juxtaposed, wherein a substrate is movable relative to the targets during sputtering.

Document EP 2 090 673 A1 describes a sputter coating installation comprising an array of targets which may be configured as rotatable magentron targets. The documents US 2009/178919 A1, US 2007/114122 A1, US 6 416 635 B1, JP 6 081145 A, WO 2010/090197 A1 and JP 63 162862 A describe various sputter systems.

### SUMMARY OF THE INVENTION

In one aspect, a method of coating a substrate is provided, which method includes forming a layer of sputtered material on the substrate. Forming the layer of sputtered material includes: sputtering material from one or more rotatable targets over the substrate; varying the relative position between the one or more targets and the substrate to a first position, which first position is maintained for a predetermined first time interval; and varying the relative position between the one or more targets and the substrate to a second position, which second position is maintained for a predetermined second time interval, wherein at least one of the predetermined first time interval and the predetermined second time interval is at least 1 second.

In yet another aspect, a system for coating a substrate is provided. The system includes one or more rotatable targets for sputtering material on said substrate, wherein the one or more rotatable targets are configured to be moved during coating of said substrate in a manner such that the relative position between the one or more rotatable targets and the substrate is varied. The system includes the further features as specified in claim 12.

Further aspects, advantages and features of the present invention are apparent from the dependent claims, the description and the accompanying drawings.

### BRIEF DESCRIPTION OF THE DRAWINGS

A full and enabling disclosure, including the best mode thereof, to one of ordinary skill in the art is set forth more particularly in the remainder of the specification, including reference to the accompanying figures wherein:
Figs. 1, 2, 3; 5 to 7; and 11 to 19 are schematic views of exemplary systems for coating a substrate according to embodiments described herein;
Figs. 4 and 10 are schematic diagrams of a voltage waveform applied to a cathode assembly according to embodiments described herein; and
Figs. 8 and 9 are qualitative diagrams illustrating formation of a layer of sputtered material according to embodiments herein.

### DETAILED DESCRIPTION OF THE INVENTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Embodiments described herein include methods of and systems for coating a substrate with a layer, in which a distribution of sputtered material over the substrate is varied during the process for forming the layer. In particular, embodiments described herein include varying the relative position between a target and a substrate (also referred to as target-substrate relative position). Typically, this relative position is maintained for a predetermined time interval at at least two distinct positions (hereinafter referred to as first position and second position), as further discussed below.

At least some other embodiments include rotating, in a reciprocating manner, in particular a planar target, more particularly about a longitudinal axis thereof or, of a planar cathode assembly associated thereto, as further discussed below. The term reciprocating, as used herein, refers to a to-and-fro motion. According to embodiments described herein, a rotatable target or an array of rotatable targets is moved in a reciprocating manner.

According to certain embodiments, sputtering a material from at least one target includes superposing two substantially complementary film distributions, as further discussed below. The term "substantially" within the present disclosure is to be understood as indicating near, approaching, or exactly a certain state or value, for example including a deviation of less than 20% or, more specifically, 10% or, even more specifically, 5%.

Thereby, embodiments of the present disclosure facilitate formation of layers on a substrate, the layers having a high quality. In particular, the thickness of the deposited layer on the substrate may be highly uniform throughout the whole substrate. Furthermore, thereby a high homogeneity of the layer is facilitated (e.g., in terms of characteristics such as structure of a grown crystal, specific resistance, and/or layer stress). For instance, embodiments of the present disclosure may be advantageous for forming metalized layers in the production of TFTs (e.g., for the manufacturing of TFT-LCD displays) since, therein, the signal delay is dependent on the thickness of the layer, so that thickness non-uniformity might result in pixels that are energized at slightly different times. Moreover, embodiments of the present disclosure may be advantageous for forming layers that are subsequently etched, since uniformity of layer thickness facilitates achieving the same results at different positions of the formed layer.

Within the following description of the drawings, the same reference numbers refer to the same components. Generally, only the differences with respect to the individual embodiments are described.

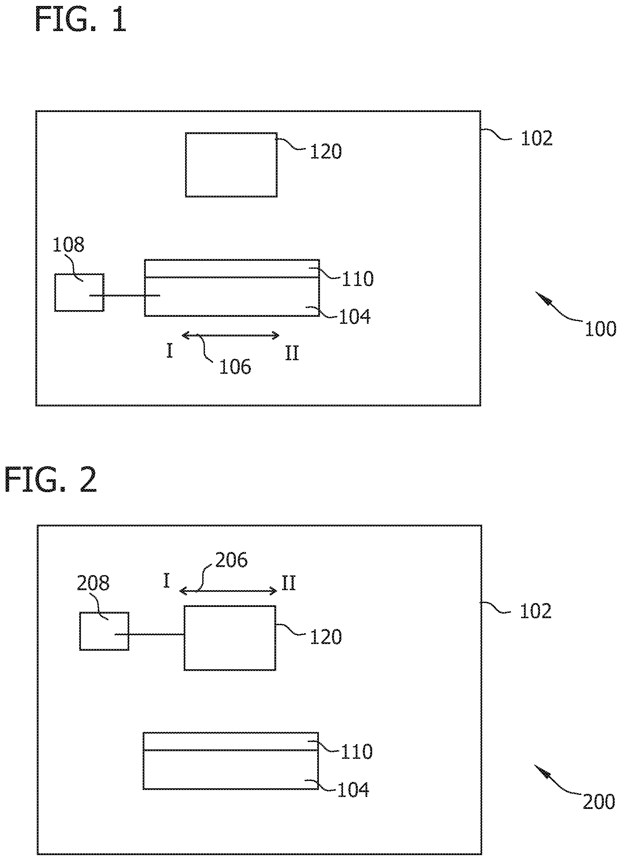

Figure 1 is a schematic view of a system 100 for coating a substrate 110. The process of coating a substrate with a sputtered material as described herein refers typically to thin-film applications. The term "coating" and the term "depositing" are used synonymously herein. The term "substrate" as used herein shall embrace both inflexible substrates (such as, but not limited to, a wafer or a glass plate) and flexible substrates (such as, but not limited to a web or a foil).

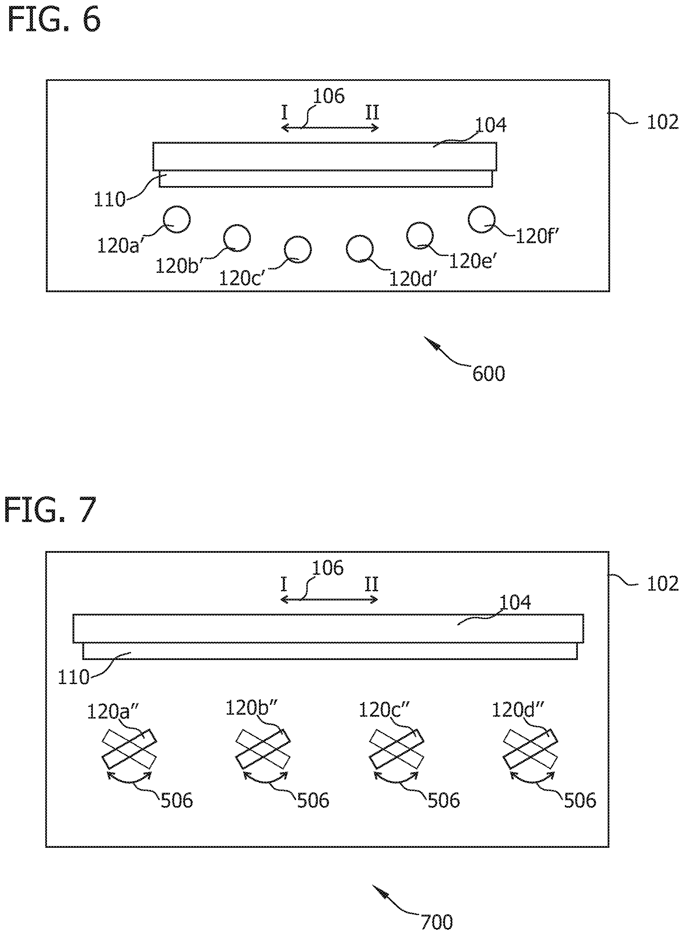

The exemplary coating system of Fig. 1 includes a target 120 placed over substrate 110, so that sputtered material from target 120 may deposit onto substrate 110. As used herein, the term "target" refers to a solid body including source material for forming a layer over a substrate by sputtering thereof. According to typical embodiments, target 120 is formed substantially cylindrical. Alternatively, target 120 may have any geometry that enables coating system 100 to form a layer as described herein. Moreover, target 120 may be constitued by a plurality of target elements as illustrated in Figs. 6 and 7. It should be noted that the term "over" merely refers to a relative position of target 120 relative to substrate 110 that facilitates sputtered material to deposit onto substrate 110. In particular, the term "over" should not be understood as being limited to an up-down vertical orientation but may refer to any suitable relative position of target 120 relative to substrate 110 that enables coating system 100 to function as described herein. In particular, both the target 120 and the substrate may be oriented vertically.

Target 120 is generally associated with or forms part of a sputtering system for performing sputtering, such as a cathode assembly (not shown) associated to target 120 as further discussed below. A coating system according to typical embodiments herein, such as exemplary system 100, constitutes a sputtering apparatus. According to typical embodiments sputtering can be undertaken as magnetron sputtering. Alternatively, but not limited thereto, sputtering may consist of diode sputtering.

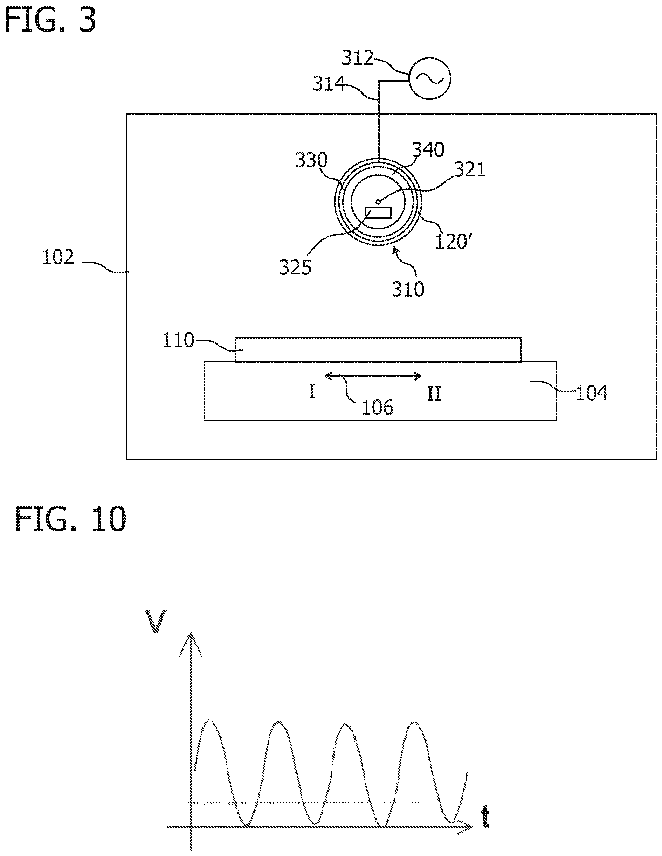

Magnetron sputtering may be particularly advantageous in that its deposition rates are relatively high. According to typical embodiments (see passages below referring to Fig. 3), which may be combined with any embodiment described herein, a magnet is associated to target 120 in a manner such that a magnetic field may be generated in the proximity of the target surface opposite to the substrate surface to be coated. Thereby, free electrons may be trapped within the generated magnetic field, so that the free electrons are not free to bombard the substrate to the same extent as with diode sputtering. At the same time, the free electrons, when trapped in the magnetic field, enhance their probability of ionizing a neutral gas molecule by several orders of magnitude as compared to diode sputtering. This effect may increase the available ions, thereby significantly increasing the rate at which target material is eroded and subsequently deposited onto a substrate.

According to typical embodiments, coating system 100 includes a vacuum chamber 102, in which the sputtering process is performed. The term "vacuum" within the present application refers to a pressure below 10⁻² mbar (such as, but not limited to, approximately 10⁻² mbar, as the case may be when a processing gas flows within vacuum chamber 102) or, more specifically, a pressure below 10⁻³ mbar (such as, but not limited to, approximately 10⁻⁵ mbar, as the case may be when no processing gas flows within vacuum chamber 102). Coating system 100 may form a process module forming part of a manufacturing system (not shown). For example, coating system 100 may be implemented in a system for TFT manufacturing or, more specifically, a system for TFT-LCD manufacturing such as, but not limited to, an AKT-PiVot PVD system (Applied Materials, Santa Clara, CA).

According to typical embodiments, the relative position between target 120 and substrate 110 may be varied. As used herein, to vary the relative position between a target and a substrate shall be understood as modifying the placement and/or orientation of the target or the substrate in a manner such that the distribution of sputtering material deposited over substrate 110 is substantially changed from the previous relative position to the relative position after the variation.

That is, varying the relative position particularly includes a back and forth movement, an up and down movement, or a combination thereof. The present disclosure typically relates to what is called "static sputtering". Varying the relative position and moving at least one of the substrate or the one or more targets shall not be misunderstood as dynamic sputtering in which case one substrate after the other is constantly moved in front of a target in a transport direction. The present disclosure particularly relates to a relative movement of the substrate and the one or more targets in a direction that is different from the transport direction of the substrate. Different in this context may comprise any direction intersecting the transport direction (e.g., at an angle of 90°) and the direction opposite to the transport direction. The present disclosure particularly relates to a relative movement of the substrate and the one or more targets that is stopped for a selected time period.

For example, substrate 110 may be displaced (i.e. translated or rotated) relative to target 120 in a manner such that the distribution of sputtered material deposited is substantially changed. In particular, according to certain embodiments herein, varying the relative position includes displacing substrate 110 relative to target 120 along a plane substantially parallel to the surface of the substrate on which said layer of sputtered material is formed (as illustrated by substrate wobble direction 106 in Fig. 1).

For example, substrate 110 may be displaced less than 220 mm for reaching an outer position of the wobble movement or, more specifically, less than 180 mm or, even more specifically, less than 150 mm. Alternatively, substrate 110 may be displaced less than 10% of a substrate lenght for reaching an outer position of the wobble movement or, more specifically, less than 7.5 % or, even more specifically, less than 5 %. In particular, these percentages may apply to a Gen 8.5 substrate with planar dimension 2500 mm x 2200 mm.

Alternatively, target 120 may be displaced (i.e. translated or rotated) relative to target 120 in a manner such that the distribution of sputtered material deposited over substrate 110 is substantially changed. In particular, according to particular embodiments further discussed below, target 120 is a planar target which is rotated in a reciprocating manner. It should be noted that a rotation of a substantially cylindrical target (for example as found in a rotary cathode) about its symmetry axis does not lead to a substantial change in the distribution of sputtered material deposited over substrate 110, as the case may be for a rotary cathode. Therefore, such a rotation of a cylindrical target does not lead to a variation of the relative position between the target and the substrate as understood within the present disclosure. A rotary cathode is understood as a cathode assembly including or associated to a target having a substantially cylindrical form, wherein at least the target is rotatable about its axis of cylindrical symmetry, as used in, for example an AKT-PiVot PVD system. Therefore, the phrase "rotating a rotatable target" as understood herein refers to swaying the rotatable target, i.e., a movement of the rotatable target in such a way that the center of the target has a non-constant position.

In particular, according to typical embodiments, the relative position between target 120 and substrate 110 may be varied in a manner such that wobbling is performed. The term "wobbling" shall be understood as varying the relative position between target 120 and substrate 110 around a zero position. For example, but not limited to, substrate 110 and/or target 120 may be displaced or rotated from side to side (i.e., between two outer positions in a reciprocating manner). The relative position between target 120 and substrate 110 may be varied following any suitable movement pattern that enables formation of a layer on a substrate according to embodiments herein, as further illustrated below.

According to typical embodiments, which might be combined with any embodiment herein, coating system 100 includes a drive system configured to vary the relative position between a target 120 and a substrate 110 disposed on a substrate carrier 104 that may be movable. Coating system 100 may include a substrate wobble drive system 108 (as shown in Fig. 1) associated to movable substrate carrier 104 for varying the relative position by translation or rotation of substrate 110. In the exemplary embodiment, substrate wobble drive system 108 performs a translation of substrate 110 along a substrate wobble direction 106. Alternatively, substrate wobble drive system 108 may perform translation along any other direction such as a direction perpendicular to the coated surface of substrate 110. Generally, translation of substrate 110 parallel to a plane perpendicular to the main travel direction of sputtered particles (that is, for example, in the vertical direction in Fig. 1) is advantageous. Alternatively, but not limited to, wobble drive system 108 may perform a rotation of substrate 110 about a longitudinal axis thereof such as, but not limited to, a planar symmetry axis.

Substrate wobble drive system 108 may be any movement mechanism suitable for moving (in particular, effecting wobbling of) substrate carrier 104 according to embodiments herein. For example, but not limited to, substrate wobble drive system 108 may include a coupling element (not shown) for coupling a driving force generated by a driving device (not shown). The coupling element may be a driving shaft or the like. Substrate carrier 104 may be mounted on a guide system (e.g., a rail arrangement) for facilitating a horizontal (i.e., parallel to the surface of the substrate to be coated) translation thereof. The driving device may include a motor and means for converting the torque of the motor to a linear driving force, so that substrate carrier 104 and, consequently, substrate 110 may be horizontally translated. Similar driving systems may be provided for moving or, more particularly, wobbling substrate 110 along other directions, such as for rotation thereof about an axis perpendicular to the substrate surface or translation along such an axis.

Alternatively, for coating systems in which the relative position between target 120 and substrate 110 is changed by effecting a translation or appropriate rotation of target 120, a drive system acting on target 120 may be provided. Fig. 2 schematically shows such an alternative to coating system 100. In a coating system 200, target 120 is configured for being movable during layer formation along a target wobble direction 206. In such embodiments, substrate 110 may remain stationary relative to vacuum chamber 102 during the whole layer formation process. Furthermore, coating system 200 includes a target wobble drive system 208 adapted for moving (in particular, wobbling of) target 120 according to embodiments herein. In the exemplary system, target wobble drive system 208 effects a translation of target 120 along a substrate wobble direction 106. Alternatively, but not limited thereto, target wobble drive system 208 may effect a rotation of target 120 about a longitudinal axis of target 120, as further discussed below for a planar target. Target wobble drive system 208 (similar as substrate wobble drive system 108) may include an appropriate drive system (not shown) for suitably varying the target-substrate relative position by engendering movement of target 120.

According to certain embodiments, sputtering material from a target over substrate 110 includes: (a) varying the relative position between target 120 and substrate 110 to a first position I, the relative position being maintained in first position I; and (b) varying the relative position between target 120 and substrate 220 to a second position II. According to typical embodiments, the relative positions are maintained for a selected time interval, that is, the first position is maintained for a predetermined first time interval, and the second position II is maintained for a predetermined second time interval. First position I and second position II may respectively correspond to outer positions of a wobbling displacement resulting in a variation of the relative position between substrate 110 and/or target 120.

According to certain embodiments, which may be combined with any embodiment herein, the predetermined first time interval is of at least 0.1 sec., preferably of at least 0.5 sec., even more preferably of at least 1 sec.. Higher predetermined times for the time intervals are also possible, such as of at least 10 sec. or, even more, such as of at least 30 sec.. In particular, the relative position may be stayed at the outer positions (i.e., the first and second position) for a predetermined percentage of the total layer formation process or sputtering time such as at least 40 % thereof or, more specifically, at least 20% thereof or, even more specifically, at least 10 % thereof or time intervals between these percentages such as 40 to 10 % or 40 to 20 % or 20 to 10 %.

It should be noted that the layer formation process includes processing time where material is being sputtering and processing time without material being sputtered (for example, in-between two sputtering intervals during formation of one layer such as the case may be during an eventual variation of the target-substrate relative position during which no material is sputtered from the target). Sputtering may be performed only at those positions where the relative position between target 120 and substrate 110 remains stationary during the layer formation process, such as the first and second position. In that case, the predetermined percentage of time in which the relative position may be stayed at the outer positions relative to the whole sputtering time is of approximately 100%. Thereby, a particularly high uniformity may be achieved.

According to embodiments of the present disclosure, during the layer formation process, substrate 110 and/or target 120 are displaced to a first relative position for a predetermined first time. This first relative position corresponds to position I in Figs. 1 and 2. Then, substrate 110 and/or target 120 are displaced to a second relative position (position II in Figs. 1 and 2) for a predetermined second time. Such a displacement of the relative position may result in sputtered material being asymmetrically distributed over substrate 110. Such an asymmetrical distribution may result in a higher coating rate of areas that do not require coating such as the substrate holder or walls within the coating room, thereby reducing process efficiency. However, despite this situation, it has been surprisingly found out by the inventors of the present disclosure that the homogeneity of the thereby deposited layer on the substrate may be increased relative to a layer formation process in which the relative position between substrate and target is maintained unchanged during the process. It should be noted that, within this context, homogeneity of the layer generally refers to uniformity of: layer thickness throughout the coated area on the substrate, crystal structure, specific resistance, and/or layer stress.

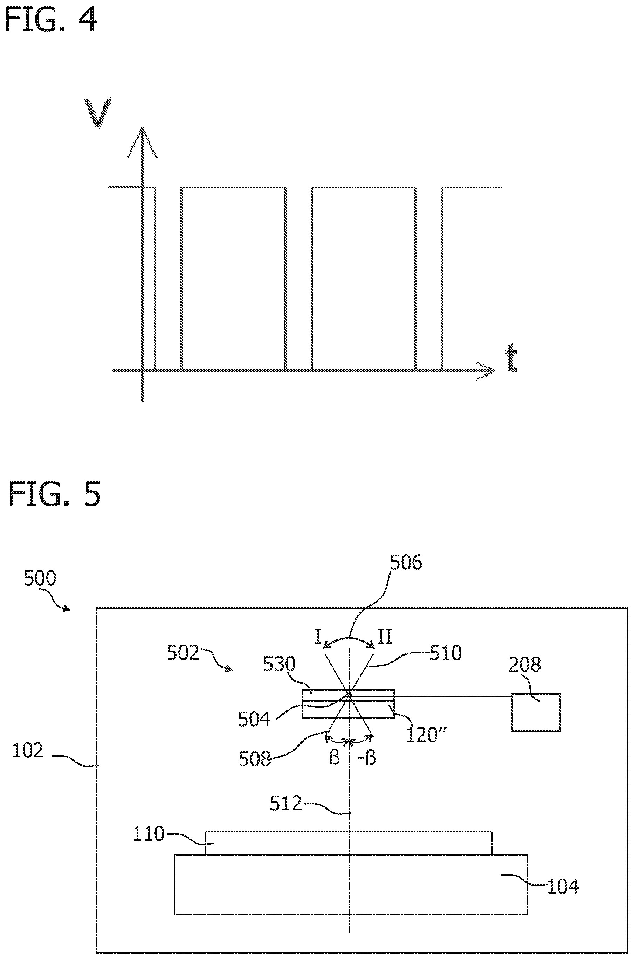

According to embodiments, target 120 is a rotatable target or, more particularly, a substantially cylindrical target rotatable about a cylindrically symmetric axis thereof. According to alternative embodiments, target 120 is a planar target (i.e. a target having a target surface adapted to be sputtered, which surface is substantially planar). Typically, such a planar substrate is associated with (i.e. forms part of) a planar cathode assembly, as further illustrated below with regard to Fig. 5. In such alternative embodiments, the relative position between target 120 and substrate 110 may be varied by rotating, in a reciprocating manner, planar target 120. In particular, planar target 120 may be rotated about a longitudinal axis thereof, i.e., about an axis substantially parallel to the target surface to be sputtered and intersecting the target body. Further details of embodiments referring to a planar target are discussed further below (see passages referring to Figs. 5 and 7).

Fig. 3 exemplarily illustrates a cathode assembly 310 as used in embodiments described herein in more detail. It is to be understood that all the elements shown in Fig. 3 may also be combined with at least some of the embodiments described herein, in particular in those embodiments described with respect to Figs. 1 and 2. Fig. 3 illustrates a rotatable cylindrical target 120' placed on a backing tube 330. In particular, but not limited thereto, rotatable cylindrical target 120' may be bonded to backing tube 330. Typically, material of target 120' is cleared away during sputtering while target 120' is being rotated about its axis of cylindrical symmetry. According to certain embodiments, cathode assembly 310 includes a cooling system 340 in order to reduce the high temperatures on the target that may result from the sputtering process. For example, but not limited thereto, cooling system 340 may be constituted by a tube containing cooling material such as water or any other suitable cooling material. Cooling might be advantageous because the major part of the energy put into the sputtering process - typically in the order of magnitude of some kilo Watts - may be transferred into heat transferred to the target. In certain situations, such heat may damage the target. According to other embodiments, the complete inner part of cathode assembly 310 is filled with an appropriate cooling material.

As shown in the schematic view of Fig. 3, cathode assembly 310 may include a magnet assembly 325. In the exemplary embodiment, magnet assembly 325 is positioned within backing tube 330. According to embodiments herein, cathode assembly may include any suitable number of magnet assemblies within backing tube 330, such as two, three, or even more. Cathode assembly 310 may include a shaft 321 associated to a driving system (not shown) for performing rotation of at least backing tube 330 and, consequently, target 120. In the exemplary embodiment, the position of shaft 321 corresponds to the cylindrically symmetric axis of target 120'. Thereby, a rotary target may be implemented in a coating system according to embodiments herein, which may facilitate a higher utilization of target material. In the exemplary embodiment, this rotation of sputtering target 120 is combined with a horizontal translation of substrate 110 for facilitating formation of a highly uniform layer of sputtered material thereon. Alternatively, rotation of sputtering target 120 may be combined with any other method suitable for varying the relative position between target 120 and substrate 110 according to embodiments herein such as, but not limited to, wobbling of the whole cathode assembly 310.

According to an aspect of the present disclosure, the voltage applied to a cathode assembly associated to a target is varied over time during the formation of a layer of sputtered material over a substrate. In other words, a non-constant voltage may be applied to the cathode assembly during sputtering. Notably, the sputter power is normally directly corresponding to the voltage applied to the cathode assembly. Apart from values close to 0 V, the relation between applied voltage and sputter power is approximately linear. Therefore, according to certain embodiments, the sputter power may be changed depending on the relative position between substrate 110 and target 120.

In the exemplary embodiment depicted in Fig. 3, voltage is applied to cathode assembly 310 (which is associated to target 120") by a voltage supply 312. In particular, voltage supply 312 may be electrically connected to backing tube 330 through an electrical connection 314 in order to apply a negative potential thereto. Backing tube 330 is constituted of a suitable material such that backing tube 330 may be operated as an electrode. Such a suitable material may be a metal such as, but not limited to, copper. According to certain embodiments, a positive electrode (i.e., an electrode which may have a positive potential during sputtering, also referred to as an anode) is positioned close to target 120" for facilitating the sputter process.

Therefore, according to embodiments herein, an electrical field may be associated to a target such as, but not limited to, exemplary targets 120 and 120', through a voltage applied to cathode assembly 310.

The inventors have observed that the uniformity of the layer formed according to embodiments herein may further improve in dependence on how long the target-substrate relative position stays at the first and second positions referred to above. In particular, the longer the target-substrate relative position is stayed at the first and second positions in relation to the overall process time, the better the homogeneity and, in particular, the uniformity gets. Therefore, the maximum homogeneity may be achieved by sputtering at those positions. It is further possible to switch off the sputtering electric field at the time of movement (i.e., where the target-substrate relative position is being varied), which may further increase the uniformity.

In particular, the inventors of the present disclosure have found out that layer homogeneity can be further increased if the electric field is reduced or switched off at times where the relative position is varied. More particularly, homogeneity can be increased if sputtering is paused at those times where the relative position between substrate and target does not correspond to wobbling outer positions. Sputtering may be paused by setting the electrical potential difference between a cathode assembly associated to the target and an associated anode close to zero or to zero.

Therefore, according to certain embodiments, varying said relative position includes the varying of the relative position referred to above from a first position to a second position, wherein a voltage provided to cathode assembly 310, associated to target 120 is higher when the relative position corresponds to the first or second position than when the relative position corresponds to a position between said first position and said second position. In particular, the voltage may be substantially zero when said relative position corresponds to a position between the first and second position. More particularly, the voltage may be varied over time according to a square waveform during the variation of said relative position.

Fig. 4 shows the voltage V applied between an anode and a cathode assembly for those embodiments where the voltage is non-constant in time but has the shape of a square wave. As it can be seen in the figure, the voltage remains at a certain constant non-zero level for some time, which is typically the first or the second time sputtering interval(i.e., where the relative position is kept unchanged). The voltage is then substantially reduced in certain time intervals. These time intervals typically correspond to those times when the relative position is being varied, e.g., when changing the relative position from the first position to the second position referred to above.

According to certain embodiments, the voltage may be 0 V at those times when it is substantially reduced. Thereby, sputtering stops almost instantaneously. According to alternative embodiments, the voltage may be reduced to a certain threshold value, which might be suitable as initial voltage for the sputtering process. For instance, such a threshold voltage may stop sputtering but may allow an easier restart of the sputter process. However, the voltage may be reduced to a value of less than 10 % of the sputter voltage (more typically of less than 5 %) of the sputter voltage at those times when the relative position between substrate 110 and target 120 is being changed.

As set forth above, a non-constant voltage may be applied to cathode assembly 310 during sputtering. According to typical embodiments, the voltage is synchronized with the relative position between target 120 and substrate 110. For instance, the voltage may be set during movement of the magnet assembly to a value of less than 35% or, more particularly, less than 20% of the maximum voltage value applied to cathode assembly 310. Fig. 10 exemplarily shows a voltage V varying over time t following a sinusoidal shape. The relative position may be synchronized with sinusoidal voltage V. For example, but not limited to, the relative position may be maintained unchanged at those times in which voltage V is larger than (i.e., above) the dotted line shown in Fig. 10. During those times in which voltage V is smaller than (i.e., below) the dotted line, the relative position may be varied from the first to the second position and vice versa in an alternating manner.

According to certain embodiments, which may be combined with other embodiments herein, the relative position is varied from the first to the second position only once during the whole formation process. According to alternative embodiments, the relative position is varied from the first to the second position and viceversa. Such a sequence of movements may be repeated a plurality of times during the whole formation process. For example, the relative position may be changed three times or more so that, when coating a substrate, the relative position respectively corresponds to the first and second position twice or more. Although such a movement pattern might increase the overall process time because of the time required for accomplishing the sequence of movements and, eventually varying the sputtering power in-between, it may result in a further increase of the layer homogeneity.

According to certain embodiments, forming a layer of sputtered material includes: (i) maintaining the relative position between substrate 110 and target 120 in a first position during a first time interval while an electrical field for sputtering is switched on; (ii) after the first time interval has lapsed, setting the relative position between substrate 110 and target 120 to a second position (for example by displacement of substrate 110, as depicted in Fig. 1, or by displacement of target 120, as depicted in Fig. 2), the electrical field being switched off during the variation of the relative position from the first to the second position; and (iii) maintaining during a second time interval the relative position between substrate 110 and target 120 in a second position while the electrical field is switched on. Thereafter, steps (ii) and (i) may then be analogously performed in this order for varying the relative position from the second position to the first position. The phrase "the electrical field being switched on" is understood as a voltage being applied to a cathode assembly associated to target 120 and an anode associated thereto. According to typical embodiments, the applied voltage is constant during the first time interval and/or the second time interval. The applied voltage may be equal at those times where the relative position corresponds to the first position and at those times where the relative position corresponds to the second position.

According to certain embodiments, illustrated in Figs. 5 and 7, a system for coating a substrate is provided, where coating systems include one or more planar targets for sputtering material on the substrate. The at least one planar target in these embodiments is rotatable in a reciprocating manner during coating of said substrate. The term "rotatable in a reciprocating manner", as used herein, should be understood as rotatable following a to-and-fro motion, that is, rotating the planar target to a first position and rotating back the planar target from the first position to a second position. The first position and the second position are also referred to as outer positions of the rotation of the planar target. According to certain embodiments, the planar target is associated to a planar cathode assembly for facilitating sputtering. The rotation of the planar target may be accomplishing by rotation of the whole cathode assembly. According to particular embodiments, the planar target is rotatable about an axis parallel to the substrate surface, in particular about a longitudinal axis of the planar target (or of the planar cathode associated therewith), more particularly, about the center axis of the planar target (or of the planar cathode associated therewith).

Fig. 5 illustrates another exemplary coating system 500 including a planar cathode assembly 502 associated to a planar target 120". It is to be understood that all the elements shown in Fig. 3 may also be combined with at least some of the embodiments described herein, in particular in those embodiment described with respect to Figs. 1 and 2. Planar cathode assembly 502 includes a planar backing body 530, which provides a support to planar target 120". In particular, planar target 120" may be bonded to planar backing body 530. Planar backing body 530 may be connected to a voltage source (not shown in this figure), so that backing body 530 functions as an electrode (in a similar manner as described above with regard to backing tube 330). Cathode assembly 502 may be associated with an anode (not shown) for providing an electric field suitable for producing sputtering from target 120" as described herein. Planar cathode assembly 502 may include other elements not shown in Fig. 5 such as, but not limited to, a magnet assembly for magnetron sputtering and/or a cooling system as described herein.

Planar target 120" is rotatable in a reciprocating manner during coating of substrate 110 such that the relative position between planar target 120" and substrate 110 is varied. In particular, planar target 120" may be varied about a pivoting axis 504. In the exemplary embodiment, pivoting axis 504 corresponds to the center axis of planar cathode assembly 502. According to embodiments herein, pivoting axis 504 may correspond to an axis parallel to the surface of substrate 110 to be coated, for example, but not limited to, a longitudinal axis of target 120". In particular, pivoting axis 504 may be off-axis of the midline of cathode assembly 502 or of target assembly 120". In general, pivoting axis 504 may correspond to any axis as long as the corresponding rotation results in a variation of the relative position between target 120" and substrate 110.

Fig. 5 illustrates angles β and -β at which planar target 120" may be rotated for varying the relative position. Angle β is the angle formed by the axis perpendicular to planar target 120" and an axis 512 perpendicular to substrate 110. Lines 508 and 510 illustrate the axes perpendicular to planar target 120" at the outer positions thereof. The value of the angle is positive for a clockwise rotation and negative for a counterclockwise rotation of target 120". The values of the angles corresponds to zero when planar target 120" is positioned parallel relative to the surface of substrate 110 to be coated. Therefore, at the outer positions of target 120" (i.e. first and second position referred to above) planar angle β corresponds to a non-zero value. In the exemplary embodiment, the absolute value of the angle is the same for both outer positions of the target (i.e., first and second positions referred to above). Alternatively, the absolute value of the angle may be different from one outer position to the other outer position. According to typical embodiments, the absolute value of the angle is less than 50 degrees or, more specifically, less than 45 degrees or, even more specifically, even less than 30 degrees.

According to typical embodiments, rotation of target 120" may be accomplished by a shaft (not shown) disposed at pivoting axis 504. Such a shaft may be coupled to a target wobble drive system 208 for generating the reciprocating rotation of target 120". For example, but not limited to, target wobble drive system 208" may include an electro-mechanical motor (not shown) and a shaft (not shown) to couple a torque generated by the motor to pivoting axis 504, so that reciprocating rotation of target 120" is engendered.

According to certain embodiments related to coating system 500 (but not limited to), a method for coating substrate 110 is provided, which method includes: forming a layer of sputtered material on said substrate 110, wherein forming the layer of sputtered material includes: sputtering material from planar target 120" over substrate110; and varying the relative position between target 120" and substrate 110 by rotating, in a reciprocating manner, planar target 120".

These latter embodiments may vary the relative position between target 120" and substrate 110 following any suitable rotation pattern. For example, planar target may be rotated with a constant angular velocity. Alternatively, rotation may be accomplished with a non-constant angular velocity. Furthermore, reciprocate rotation may be accomplished with substantially no dead time at the outer position. According to alternative embodiments, rotating planar target 120" includes: rotating target 120" to a first position, which first position is maintained for a predetermined first time interval and rotating said at least one target to a second position, which second position is maintained for a predetermined second time interval, in a similar manner as described above. Generally, the first and the second position may correspond to the outer positions in the reciprocate rotation of planar target 120".

According to certain embodiments related to coating system 500 (but not limited thereto), coating may further include providing a voltage to planar target 120", which voltage is varied over time during coating. More particularly, changing the relative position in coating system 500 may be combined with a voltage variation as described above.

According to typical embodiments, which may be combined with any embodiment herein, target 120, 120', or 120" may be constituted by a plurality of target elements spatially separated and disposed in front of substrate 110 (i.e., a target array), so that sputtered material from the target elements may be deposited thereon. In particular, each of the target elements may be associated to or form part of a cathode assembly. More specifically, the plurality of cathode assemblies may be arranged in an array of cathode assemblies. In particular, for static large-area substrate deposition, it is typical to provide a one-dimensional array of cathode assemblies that are regularly arranged. Typically, the number of cathode assemblies (and associated targets) within a processing chamber is between 2 and 20, more typically between 9 and 16.

According to array embodiments, the relative position between the target elements and substrate 110 may be varied by synchronously translating or suitably rotating the target elements. Alternatively, the relative position may be varied by displacing substrate 110 relative to the target array. Generally, the relative position between a plurality of targets and a substrate may be varied in any suitable manner that allows a coating system to function according to embodiments herein. Generally, a synchronous displacement of the target elements further increases the homogeneity of the deposited layer.

Generally, and not limited to any embodiment, the cathode assemblies may be spaced apart from each other equidistantly. In particular, the target may include an array of target elements. Furthermore, a length of the target may be slightly larger than the length of the substrate to be coated. Additionally or alternatively, the cathode array extends over a distance slightly broader than the width of the substrate. "Slightly" typically includes a range of between 100% and 110%. The provision of a slightly larger coating length/width facilitates avoiding boundary effects during coating. The cathode assemblies may be located equidistantly away from substrate 110.

According to certain embodiments, a plurality of cathode assemblies is arranged not equidistantly relative to substrate 110 but along an arc shape. The arc shape may be such that the inner cathode assemblies are located closer to substrate 110 than the outer cathode assemblies, as schematically shown in Fig. 6. Alternatively, the arc shape may be such that the outer cathode assemblies are located closer to the substrate than the inner cathode assemblies. The scattering behaviour generally depends on the material to be sputtered. Hence, depending on the application, i.e. on the material to be sputtered, providing the cathode assemblies on an arc shape will further increase the homogeneity of the formed layer. The orientation of the arc generally depends on the particular application.

Fig. 6 shows an exemplary coating system 600, in which variation of the relative position between substrate 110 and a target array including target elements 120a' to 120f' is accomplished by a horizontal translation of substrate 110 (in particular wobbling thereof) along substrate wobble direction 106. In the exemplary embodiment target elements 120a' to 120f' are rotatable cylindrical targets. In alternative embodiments, target elements may have any suitable shape.

Fig. 7 shows another exemplary coating system 700 including an array 120" of planar targets 120a" to 120d". Each of planar targets 120a" to 120d" may be constituted similarly as planar target 120", illustrated in Fig. 5. Accordingly, in the exemplary coating system 700, variation of the relative position between the array of planar targets 120a" to 120d" is accomplished by a synchronous reciprocating rotation of the targets about respective pivoting axis 504 in the pivoting direction 506. Each of planar targets 120a" to 120d" may be rotated an angle β similarly as described above regarding Fig. 5. In the figure, one outer position of each of planar targets 120a" to 120d" is illustrated by the elements in thick lines, and the other outer position thereof is illustrated by the elements in thin lines. As depicted in Fig. 7, substrate wobbling and target wobbling may be combined for performing target-substrate relative displacement.

According to a particular embodiment, which may be combined with other embodiments of the present disclosure (in particular those providing multiple cathodes asssemblies, such as, but not limited to, those shown in Figs. 6 and 7), sputtering a material from at least one target may include superposing at least two substantially complementary film distributions. In particular, embodiments described herein include choosing the first position and the second position in a manner such that two substantially complementary film distributions are superposed by the formation of the layer of sputtered material. By "complementary film distribution" is meant that the maximal thickness regions of material sputtered at a relative target-substrate position (first maxima) are distributed so that they are placed in-between two maximal thickness regions of material sputtered at another relative target-substrate position (second maxima). More specifically, first and second maxima may be distributed so that the regions of the layer deposited layer with a maximal thickness are equally spaced. Thereby, formation of a highly uniform layer is facilitated.

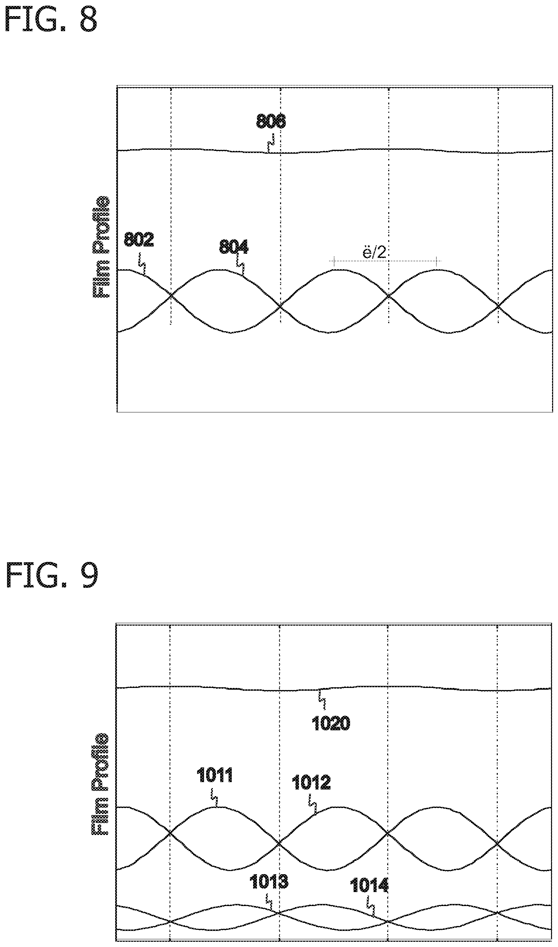

In particular, according to embodiments herein, sputtering a material from at least one target may include superposing at least two film distributions having a thickness periodically varying along a length of the substrate with a periodicity length λ (shown in Fig. 8). According to certain embodiments, varying the target-substrate relative position is performed in a manner such that the at least two film distributions are out of phase one respect the other. For example, the phase of the periodicity of the at least two film distributions may differ in π/2 or less.

Fig. 8 illustrates an embodiment in which two substantially complementary film distributions are superposed. The y-axis represents a metrical unit for the film's height, whereas the x-axis represents a metrical unit for the substrate's length. The deposition takes place by an array of cathode assemblies so that each deposition setting results in substantially sinusoidal film distributions. The two deposition profiles are the resulting profiles from sputtering at two different positions. In the example, a first film distribution 802 is formed at a first target-substrate relative position. In the example, the relative position between the target and the substrate is varied to a second target-substrate relative position.

The relative position may be varied according to any of the embodiments herein. For example, the substrate may be translated along a horizontal direction or the target (or target array) may be translated or suitably rotated as described above. At the second target-substrate position, a second film distribution 804 is formed according to embodiments herein. From the superposition of both film distributions, a layer 806 results, which have a higher uniformity than the first and second film distributions. It should be noted that in the schematic diagram depicted in Fig. 8, film thickness and substrate length (X) is illustrated in arbitrary units (a.u.).

According to certain embodiments, the relative position between the target and the substrate may be positioned stationary during predetermined times in further positions than the first and the second position referred to above during the layer formation. Thereby, uniformity of the layer may be further enhanced. Such further positions are placed in-between the first and the second positions. For example, the relative position may be positioned at a third position for a third predetermined period of time (i.e., a third time interval) or, eventually, at a fourth position for a fourth predetermined period of time (i.e., a fourth time interval). The relative position may remain stationary at even further positions during the layer formation.

The inventors of the present application have found that such further positions facilitate a higher degree of homogeneity of the deposited layer. In particular, formation of the layer of sputtered material may include superposing a plurality of sub-layers, each sub-layer being deposited at a predetermined sputtering voltage and at a predetermined relative target-substrate position. For example, each sub-layer may be deposited by an array of planar target elements (as shown in Fig. 8), with each target element forming an angle β relative to an axis perpendicular to the surface of the substrate to be coated.

For this latter embodiment, the inventors have observed that arcing increases non-linearly with increasing process powers and angles of the planar targets. The inventors have found that, for such embodiments, a high degree of uniformity may be obtained by the superposition of several sub-layers (for example four sub-layers), wherein each sub-layer is deposited at a specific voltage and at a specific angle. For example, high uniformity may be obtained by superposing several sub-layers, the sub-layers sputtered at high angles corresponding to low sputtering voltages and the sub-layers sputtered at low angles corresponding to high sputtering voltages. Thereby, high throughput time and layer uniformity may be optimized.

According to one embodiment, a first deposition step is undertaken at a first target-substrate relative position (e.g., with the target elements of Fig. 7 forming an angle β1) and the sputtering voltage being set to a first voltage value for a predetermined first time interval. This is followed by a second deposition step, in which target-substrate relative position is varied to a second position (e.g., with the target elements of Fig. 7 forming an angle β2 equal to -β1), and the voltage is set to the first voltage value for the predetermined first time interval. The second position may correspond to the first position mirrored about the target-substrate interconnection plane (i.e. a plane perpendicular to the substrate surface to be coated when the relative position is at the zero position, which typically corresponds to a symmetric arrangement of the target-substrate assembly). For example, four sub-layers may be formed at angles β having the values 35°,15°, -15°, and -35°.

According to this embodiment, a further deposition step is undertaken at a third target-substrate relative position (e.g., with the target elements of Fig. 7 forming an angle β3), and the voltage is set to a second voltage value for a predetermined second time interval. This is followed by a fourth deposition at a fourth target-substrate relative position (e.g., with the target elements of Fig. 7 forming an angle β4 equal to -β3), and the voltage is set to the second voltage value for the predetermined second time interval. The fourth position may correspond to the third position mirrored about the target-substrate interconnection plane.

The predetermined first time interval and the predetermined second time interval may be identical. Alternatively or additionally, the predetermined third time interval and the predetermined fourth time intervals referred to above may be identical. The term "identical" as used herein shall be understood as including a deviation of maximally 15%. According to certain embodiments, the first time interval is larger than the second time interval. For instance, the first time interval may be between 20 seconds and 1 min., for example about 30 sec. Generally, the second time interval is a compromise between maximum uniformity and acceptable overall deposition time. Typically, the second time interval is less than 30 sec. or even less than 15 sec.

In this embodiment, the first voltage value is larger than the second voltage value. With regard to an application of this embodiment to coating system 500 or coating system 700, the absolute value of angles β1 and β2 may be smaller than the absolute value of angles β3 and β4. Most of the material may be deposited during the deposition at the first voltage. One or more of the typical values can be chosen as follows. The first voltage may be of at least 40 kW. The second voltage may be smaller than 30 kW. Angle β1 may be of between 15 and 35 degrees. Angle β2 may be of between -15 and -35 degrees. Angle β3 may be of between 5 and 15 degrees. Angle β4 may be of between -5 and -15 degrees. It should be noted that sputtering during time intervals where the target-substrate relative position is stayed at further positions than the first and second position may be also implemented by an appropriate displacement of the substrate as described in embodiments herein.

According to certain embodiments, the sputtering voltage is kept at a first non-zero value during positioning the first position and during positioning at the second position for a predetermined time interval. Additionally or alternatively, the voltage is kept at a second non-zero value during positioning at the third position and during positioning at the fourth position for another predetermined time interval. The first non-zero value may be larger than the second non-zero value. That is, the voltage may be non-zero at those times where the target-substrate relative position stays at one or all of the first, second, third or fourth positions. In particular, the voltage may be reduced to a value of less than 10 % or, more typically of less than 5 % of the first non-zero value or the second non-zero value during variation of the target-substrate relative position.

Alternatively to keeping the relative position between substrate and target constant at one or more positions for a selected time period, it is also possible to constantly change the relative position. For instance, a substrate may be constantly moved in relation to a target or an array of targets. Typical movement speeds are between 0.5 and 5 m/min, typically between 1 and 3 m/min. Likewise, the target or the array of targets may constantly be moved in relation to the substrate. The relative movement may include all possible dimensions, in particular a movement that varies the distance between the substrate and the target or the array of targets.

Generally, and not limited to any particular embodiment, in case of more than one target element, the relative position variation is maximally as large as the distance between two target elements. Typically, the relative position variation is maximally as large as half the distance between two target elements. That is, for instance, the substrate and/or the targets are moved maximally a distance that corresponds to the distance between the target elements, or, according to some embodiments, a distance that corresponds to half of the distance between the target elements.

Fig. 9 schematically shows several film profiles, i.e. distributions of sputtered material corresponding to different target-substrate relative positions measured after the layer formation process using an array of cathode assemblies. The film profiles are depicted in a similar manner as in Fig. 8.

The deposition at a first target-substrate position results in a film profile 1011, and the deposition at a second position results in a film profile 1012. Such film profiles may be the result of a relatively high sputtering voltage at a relatively small displacement of the target-substrate position relative to the zero position. A relatively small displacement refers to a position where the target array is symmetric with respect to a perpendicular mid-plane of the substrate and/or, in the case of planar targets, the planar targets are disposed parallel to the substrate. The terms high and small are relative to the third and fourth deposition steps set forth below. The deposition at a third position results in a film profile 1013, and the deposition at a fourth position results in a film profile 1014. Film profiles 1013 and 1014 may be the result of a relatively small voltage with a relatively high angle (in relation to the depositions at the first and second position).

The resulting overall film profile is shown as profile 1020. It is a superposition of the four depositions with the film profiles 1011, 1012, 1013, and 1014. As it is evident from the schematic drawing, the resulting profile has a high degree of uniformity. Further, the process time is acceptable since the major material deposition takes place during the first and second deposition step. Since this requires high deposition power, i.e. high voltage, the displacement from the zero relative position is relatively small as compared to the third and fourth deposition steps. Thereby arcing effects may be reduced or even avoided. As it can be seen in the example Fig. 9, the phase difference between the deposited layers 1011 and 1012, however, is smaller than 180° so that the ripple is only partially compensated.

As Fig. 9 illustrates, a resulting lack of uniformity of a layer formed by substantially complementary film distributions may be compensated for by performing the third and fourth deposition steps. That is, these steps mainly aim at compensating for the wave shape of the film profile produced by the first and second deposition step. The displacement from the zero relative position in the third and fourth process step is comparably large. The overall material deposition of the third and fourth process step is small since the deposition power, i.e. the voltage, is kept at a comparably small value in order to avoid arcing. As can be seen in the example illustrated in Fig. 9, the phase difference of the deposited layers 1013 and 1014 is larger than 180°. Thus, typically, the resulting sinusoidal profile is out of phase with the cathode array periodicity and/or the layer profiles of the first and second deposition so that the remaining ripple is compensated.

Any suitable sequence alternative to the described sequence of steps is possible. In particular, in order to reduce time required for the variation of the target-substrate relative position, it is possible to firstly undertake the first and third steps, and secondly the second and fourth steps. Generally, the particular order of the four deposition steps is determined by the process cycle-time and the morphological film characteristics.

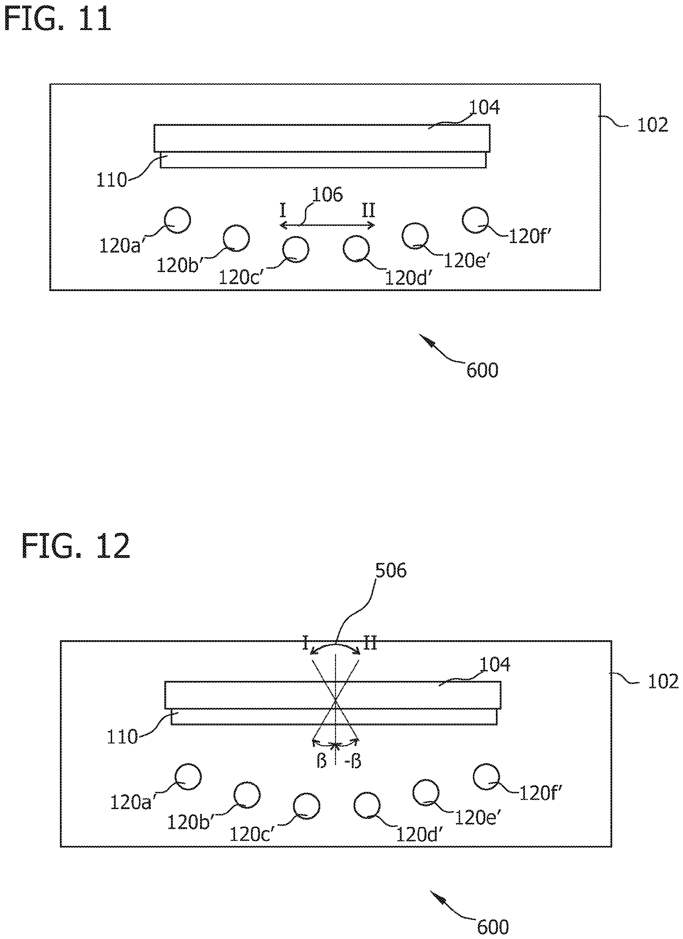

Fig. 11 shows an exemplary coating system 600, in which variation of the relative position between substrate 110 and a rotatable target array including rotatable target elements 120a' to 120f' is accomplished by a translation of substrate 110 (in particular wobbling thereof) along substrate wobble direction 106. In the exemplary embodiment target elements 120a' to 120f' are rotatable cylindrical targets.

Hence, generally and not limited to the embodiments shown in the Figures, the moving direction of the substrate relative to the target elements (or the array of target elements) can be such that the distance between the substrate and the target elements remains constant. The phrase "the distance between the substrate and the target is constant" in this context is to be understood that every point on the surface of the substrate remains at constant distance to the plane of the one or more targets. That is, typically, the relative position between target element and substrate is varied in a direction parallel to the substrate's surface.

More particularly, as exemplarily illustrated in particular in the embodiments shown in Figs. 3, 6, and 11, the relative movement between substrate and the one or more targets may take place perpendicular to the rotation axis of the rotatable targets but, according to embodiments, at a constant distance to between substrate and the one or more targets. This direction can also be called "X-direction".

According to further embodiments, which are, however, combinable with other embodiments described herein, one of the substrate and the target are rotated. For instance, rotation can take place in a reciprocating manner, the substrate thereby changing the relative position between the substrate and the one or more target elements. Fig. 12 shows an exemplary embodiment of a coating system that is adapted for rotating the substrate. For illustrative purposes, the angle β is shown in Fig. 11. In the exemplary embodiment, the absolute value of the angle is the same for both outer positions I and II of the substrate. Alternatively, the absolute value of the angle may be different from one outer position to the other outer position. According to typical embodiments, the absolute value of the angle is less than 50 degrees or, more specifically, less than 45 degrees or, even more specifically, even less than 30 degrees. In some embodiments, the substrate is held at the outer positions (I and II), according to other embodiments, the substrate is constantly moved.

The change of the relative positions illustrated so far describes a movement of the target elements and/or the substrate that is typically parallel to the substrate surface. Illustrated in view of the following figures, it is also possible to vary the relative position between the at least one target and the substrate such that the distance between the at least one target and the substrate is varied. In other words, the relative position is varied such that the substrate and the one or more targets move towards each other and/or away from each other. For instance, the distance might be reduced at first, and the distance might be increased again after that, for example, after a rest at a position.

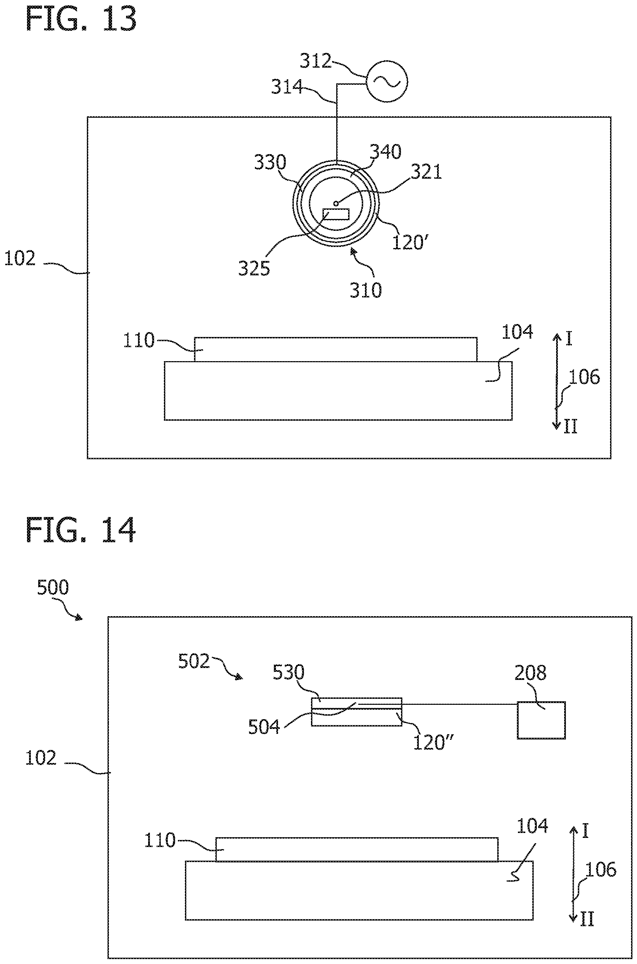

Fig. 13 illustrates embodiments wherein the substrate 110 is positioned in front of a cylindrical target 310, and Fig 14 shows embodiments wherein the substrate 110 is positioned in front of a planar target 530. The orientation of the substrate and the targets may be horizontal or vertical. For illustrative purposes Figs. 13 and 14 illustrate only one target although the provision of a multitude of targets is also possible. As indicated by the arrow 106, the relative position of the substrate 110 and the planar cathode assembly 502 is varied by varying the position of the substrate carrier 104. For instance, if the substrate's orientation is horizontal, the substrate may be lifted and lowered. If the substrate's orientation is vertical, the substrate may be moved forth and back (in the direction to the target). Either way, the overall distance between the substrate and the target is varied, and so is the coating distribution on the substrate leading to an improved coating result as described.

The phrase "the overall distance between target and substrate is varied" is to be understood that the substrate, as a whole, moves towards the target and/or away from the target. Alternatively or additionally, the target, as a whole, moves towards the substrate and/or away from the substrate. Hereto in contrast, the term "rotating" implies that some points of the target and substrate surfaces get closer, whereas, at the same time, other points of the target and substrate get further away from each other. "Rotating" the substrate or the one or more targets typically includes that at least the axis of rotation (which typically lies within or on the target or the substrate) remains at a constant distance to the one or more targets or substrate.

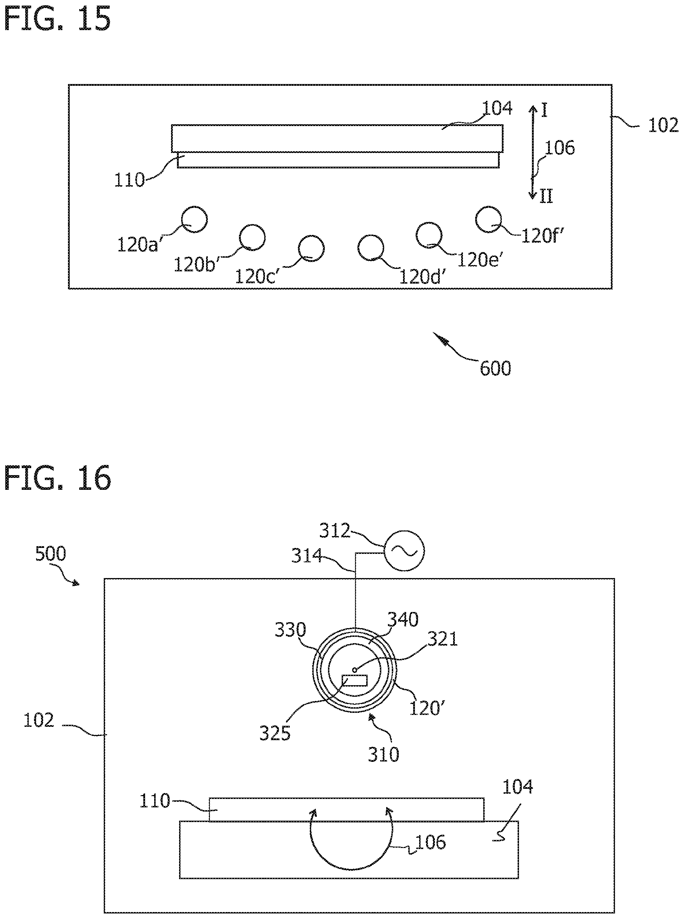

Generally, a variation of the relative position such that the distance between the substrate and the target is non-constant is possible also in case of an array of targets. Typically, the relative movement direction between substrate and target takes places along a perpendicular of the substrate's surface. This shall be called "Z-direction" herein. For instance, Fig. 15 shows an array of rotatable targets 120a' to 120f' in relation to which the substrate is moved forth and back (or, in case the substrate orientation is horizontal, up and down), for instance, in a reciprocating manner. Not illustrated but likewise possible is the arrangement of an array of planar cathode assemblies instead of the array of rotatable targets.

According to some embodiments, instead or additionally to the movement of the substrate, it is possible to move the target or the array of target elements.

The present disclosure is directed at a relative variation of the position of the substrate in relation to the at least one target. Whereas it is possible to provide a one-dimensional movement of either or both the substrate and/or the target, it is also possible to provide a rotational movement as illustrated with respect to Figures 5, 7, and 11. Accordingly, in these embodiments, the target and/or the substrate are rotated around an axis which is normally the axis of center of gravity of the substrate or the at least one target.

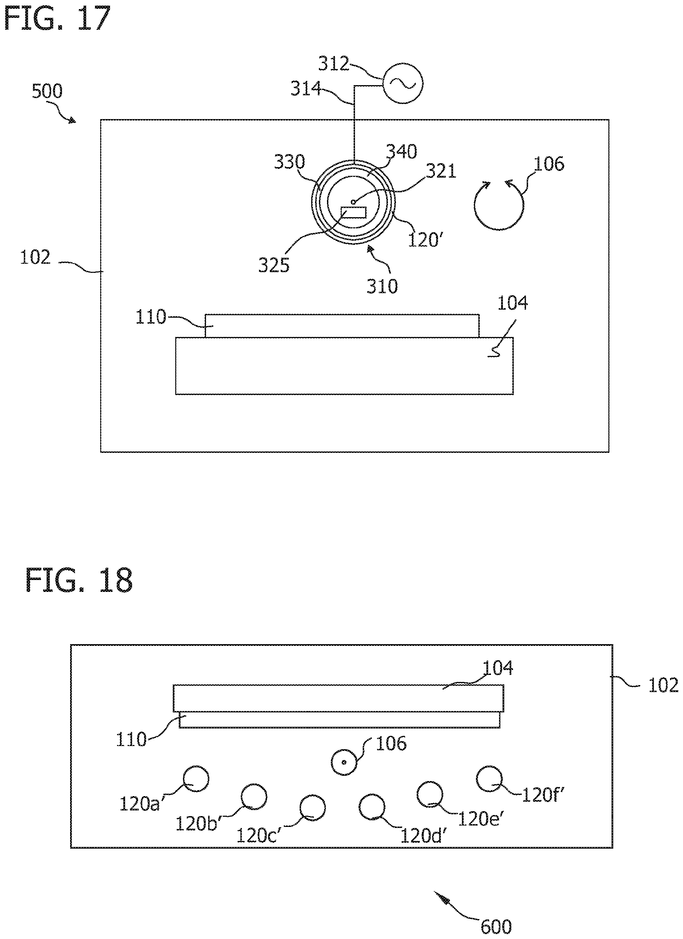

Figs. 16 and 17 illustrate a circular relative movement between substrate and target. Although this is illustrated with respect to a single rotatable cathode assembly in Figs. 16 and 17 , it is to be understood that the same relative movement can be provided in case of an array of rotatable cathode assemblies, or in case of one or more planar cathodes.

According to the embodiments illustrated in Figs. 16 and 17, the substrate is moved in a circular manner. The term "circular" in this context includes also movement paths that have a complete or partial elliptic shape. Generally, "circular" in this context shall particularly indicate that the movement of the substrate and/or the targets is more than one-dimensional, for instance, two-dimensional. Although an almost complete circle is shown in Figs. 16 and 17, the movement may cover only part of a circle or an elliptic, such as a sector of maximally 90° or even 60°.

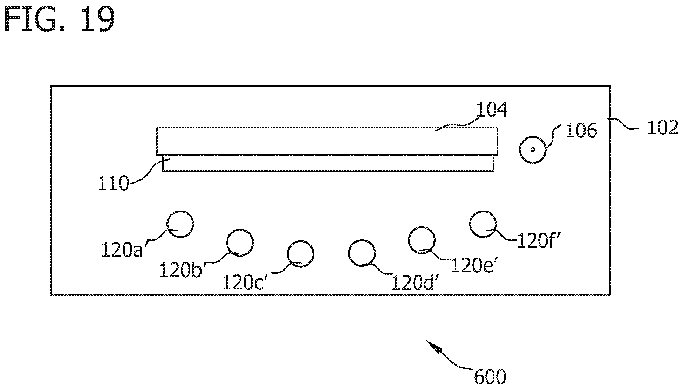

Figs. 18 and 19 illustrate embodiments of the present disclosure wherein the relative position between the one or more target elements and the substrate is varied in a direction parallel to the one or more target elements. As shown, the target elements may be rotatable targets wherein their axis of rotation defines the direction in which the relative position variation takes place. The direction defined by the axis of rotation of the rotatable targets shall be called "Y-direction". As illustrated in Fig. 18, the one or more targets may be moved in the Y-direction. As illustrated in Fig. 19, the substrate may be moved in the Y-direction. It is also possible that both the substrate and the one or more targets are moved, for instance, in the Y-direction.

Although one might expect the distribution of the sputtered material to remain identical in case of a relative movement in the Y-direction, experiments have shown that the overall layer uniformity can also be improved by a relative position variation along the Y- direction.

Generally, and not limited to this embodiment, embodiments described herein include a one-dimensional movement, either in the X-direction, the Y-direction, the Y-direction, or a one-dimensional movement in a superposition of these directions. Other embodiments provide for a more than one-dimensional movement , for instance, in a two-dimensional plane parallel to the substrate's surface (e.g., in the X-Y-plane), in a two-dimensional plane intersecting (e.g., at an angle of 90°) the substrate's surface (for instance, in the X-Z-plane or the X-Y-plane), or even in a three-dimensional manner (thus including all three directions X, Y, and Z).

Embodiments described herein may further provide for or make use of a holding device adapted for holding a mask and the substrate during processing of the substrate, e.g. while depositing material on the substrate surface. In case the substrate is moved during processing, the holding device is also moved. The holding device is typically constantly connected to the substrate during sputtering. In particular, the holding device may include a substrate carrier adapted for carrying the substrate; and a mask for masking the substrate, wherein the mask is releasably connected to the substrate carrier. The substrate carrier or the mask has typically at least one recess adapted for receiving a cover for covering the substrate carrier during deposition.

According to typical embodiments, the mask is used for keeping an uncoated area on the substrate, typically around the substrate's edges. This can become necessary for several static array applications.

For further details of the masking, in particular of the masking of the substrate's edges, it is referred to the European patent application with application number 10177419 (filed on September 17, 2010 in the name of Applied Materials, Inc.), and the US patent application with application number 12/890,194 (filed on September 24, 2010 in the name of Applied Materials, Inc.), which are incorporated herein by reference to the extent in which these document are not inconsistent with the present disclosure, and in particular those parts thereof describing the masking of the edges of a substrate.

Embodiments of the present disclosure further include a method of coating a substrate, the method including forming a layer of sputtered material on the substrate, wherein forming the layer of sputtered material includes superposing at least two different film distributions. Each of these film distributions may be formed according to any of the embodiments above, i.e., by varying the relative target-substrate position and performing sputtering during predetermined time intervals. Alternatively, these film distributions may be formed by magnet wobbling as described in the PCT application "Method For Coating A Substrate And Coater" filed by Applied Materials with the European Patent Office on September 30, 2010, which is incorporated herein by reference to the extent the application is not inconsistent with this disclosure and in particular those parts thereof describing formation of different material distributions at different magnet assembly positions.

According to at least some of the latter embodiments, the at least two film distributions are substantially complementary. Furthermore, sputtering material may be performed from a plurality of targets disposed such that the at least two film distributions are shaped in a substantially sinusoidal form.

According to typical embodiments, the relative position is varied during layer formation in a manner such that the layer of sputtered material is formed having a thickness uniformity of at least ±10 %, preferably of at least ±5 %, even more preferably of at least ±1 %.

According to certain embodiments, which may be combined with any embodiment disclosed herein, in addition to an eventual wobble of the substrate, the substrate may be continuously moved (e.g., but not limited to, by a substrate conveyor) in one direction during coating (i.e. "dynamic coating"). According to alternative embodiments, but not limited thereto, the substrate to be coated is positioned at a zero-position or is wobbled about the zero-position, the zero-position remaining static during coating ("static coating"). Generally, static coating facilitates higher efficiency as compared with dynamic coating, since during dynamic coating the substrate conveyor may be coated as well. Static coating particularly facilitates coating of large-area substrates. According to typical embodiments, by static coating, the substrate is entered into a coating area where layer formation is performed, coating is performed, and the substrate is transported out of the coating area again.

According to certain embodiment, a conductive layer manufacturing process and/or system is provided, which manufacturing process and/or system may be for fabrication of an electrode or a bus (in particular in a TFT), the manufacturing process and/or system respectively including a method of and/or a system for coating a substrate according to embodiments herein. For example, but not limited to, such a conductive layer may be a metal layer or a transparent conductive layer such as, but not limited to an ITO (indium tin oxide) layer.

At least some embodiments of the present disclosure are particularly directed to coating of large area substrates. Generally, the term "large area substrates" include substrates with a size of at least 1500 mm x 1800 mm. According to certain embodiments, a TFT-LCD display manufacturing process and/or system is provided, the TFT-LCD display manufacturing process and/or system respectively including a method of and/or a system for coating a substrate according to embodiments herein.

According to other embodiments, a thin-film solar cell manufacturing process and/or system is provided, the thin-film solar cell manufacturing process and/or system respectively including a method of and/or a system for coating a substrate according to embodiments herein. According to a particular embodiment, the thin-film solar cell manufacturing process includes sputtering of a TCO layer and/or a back contact layer. Optionally, the thin-film solar cell manufacturing process includes deposition of an absorbing layer by chemical vapor deposition.

For example, at least some embodiments of the present disclosure may yield a high uniformity on resistivity of an aluminium layer formed on a glass substrate. For example a sheet resistance Rs uniformity between ±1 % and ±4 % or even between ±0.5 % and ±3 % over a substrate area of 406 mm x 355 mm may be achieved.

According to certain embodiments, a plurality of cathode assemblies each including a target, such as a rotatable cylindrical target or a planar target, are provided for coating large area substrates. The room adapted for coating a substrate shall be called "coating room". A plurality of coating rooms may be provided, each coating room being adapted for coating one substrate at one point in time. A multitude of substrates can be coated one after the other.

Exemplary embodiments of systems and methods for coating systems are described above in detail. The systems and methods are not limited to the specific embodiments described herein, but rather, components of the systems and/or steps of the methods may be utilized independently and separately from other components and/or steps described herein.

Although the embodiments shown in the figures illustrate a target to be arranged above a horizontally arranged substrate, it shall be mentioned that the orientation of the substrate in space can also be vertical. In particular, in view of large-area coating, it might simplify and ease transportation and handling of a substrate if the substrate is oriented vertically. In other embodiments, it is even possible to arrange the substrate somewhere between a horizontal and a vertical orientation.

Within the present disclosure, at least some figures illustrate cross sectional schematic views of coating systems and substrates. At least some of the illustrated targets are shaped as a cylinder. In these drawings, it should be noted that the target extends into the paper and out of the paper when looking at the drawings. The same is true with respect to magnet assemblies that are also only schematically shown as cross sectional element. The magnet assemblies may extend along the complete length of the cylinder defined by a cylindrical target. For technical reasons, it is typical that they extend at least 80 % of the cylinder length, more typically at least 90 % of the cylinder length.

As used herein, "a," "an," "at least one," and "one or more" are used interchangeably. Also herein, the recitations of numerical ranges by endpoints include all numbers subsumed within that range "e.g., 1 to 5 includes 1, 1.5, 2, 2.75, 3, 3.80, 4, 5, etc.).

Although specific features of various embodiments of the invention may be shown in some drawings and not in others, this is for convenience only. In accordance with the principles of the invention, any feature of a drawing may be referenced and/or claimed in combination with any feature of any other drawing.

This written description uses examples to disclose the invention, including the best mode, and also to enable any person skilled in the art to practice the invention, including making and using any devices or systems and performing any incorporated methods. Especially, mutually non-exclusive features of the embodiments described above may be combined with each other. The patentable scope of the invention is defined by the claims.

## Claims

1. A method of coating a substrate (110), said method comprising:
forming a layer (806) of sputtered material on said substrate (110), wherein forming said layer of sputtered material includes:
- sputtering material from at least one rotatable target (120') over said substrate (110); and
- varying the relative position between said at least one rotatable target (120') and said substrate (110) to a first position (I), which first position is maintained for a predetermined first time interval; and
- varying the relative position between said at least one rotatable target and said substrate to a second position (II), which second position is maintained for a predetermined second time interval,
wherein at least one of the predetermined first time interval and the predetermined second time interval is at least 1 second.

2. The method of coating according to claim 1, wherein the at least one rotatable target (120') is an array of rotatable targets.

3. The method of coating according to any of the preceding claims, further comprising:
- providing a voltage to a cathode assembly (310, 502) associated to said rotatable target (120', 120"),
wherein varying said relative position includes to vary said relative position from said first position to said second position, said voltage being higher when said relative position corresponds to said first or second position than when said relative position corresponds to a position between said first position and said second position.

4. The method of coating according to claim 3, wherein said voltage is substantially zero when said relative position corresponds to a position between said first and second position and/or said voltage is varied over time according to a square waveform during the variation of said relative position.

5. The method of coating according to any of the preceding claims, wherein said relative position is varied in a manner such that said layer of sputtered material is formed having a thickness uniformity of at least ± 10 %, preferably of at least ± 5 %, even more preferably of at least ± 1 %.

6. The method of coating according to any of the preceding claims, wherein varying said relative position includes displacing said substrate (110) relative to said at least one rotatable target (120) along a plane substantially parallel to the surface of the substrate on which said layer of sputtered material is formed.

7. The method of coating according to any of the preceding claims, wherein said rotatable target is a substantially cylindrical target (120') rotatable about a cylindrically symmetric axis thereof.

8. The method of coating according to any of the preceding claims, wherein the relative position between said at least one target and said substrate is varied by varying the distance between said at least one target and said substrate.

9. The method according to any of the preceding claims, wherein sputtering a material from the at least one target (120) includes superposing at least two film distributions (802, 804).

10. The method according to claim 9, wherein said at least two film distributions (802, 804) are substantially complementary.

11. The method according to claim 8 or 9, wherein sputtering material is performed from a plurality of preferably rotatable targets (120a', 120b', 120c', 120d', 120e', 120f, 120a", 120b", 120c", 120d") disposed such that said at least two film distributions are shaped in a substantially sinusoidal form.

12. A system for coating a substrate, said system comprising at least one rotatable target (120') for sputtering material on said substrate (110), wherein said at least one rotatable target (120') is configured to be moved during coating of said substrate (110) in a manner such that the relative position between said at least one rotatable target (120) and said substrate (110) is varied from a first position (I), which first position is maintained for a predetermined first time interval to a second position (II), which second position is maintained for a predetermined second time interval, wherein at least one of the predetermined first time interval and the predetermined second time interval is at least 1 second.

13. The system for coating a substrate according to claim 12, wherein the at least one rotatable target (120') is an array of rotatable targets (120a', 120b', 120c', 120d', 120e', 120f').

14. The system for coating a substrate according to claim 12 or 13, wherein said at least one target is configured to be moved during coating of said substrate (110) in a manner such that the distance between said at least one target (120; 120'; 120") and said substrate (110) is varied.

## Patentansprüche

1. Verfahren zum Beschichten eines Substrats (110), umfassend:
Bilden einer Schicht (806) aus gesputtertem Material auf dem Substrat (110), wobei das Bilden der Schicht aus gesputtertem Material umfasst:
- Sputtern von Material von mindestens einem drehbaren Target (120') über das Substrat (110); und
- Variieren der relativen Position zwischen dem mindestens einen drehbaren Target (120') und dem Substrat (110) zu einer ersten Position (I), wobei die erste Position für ein vorbestimmtes erstes Zeitintervall aufrechterhalten wird; und
- Variieren der relativen Position zwischen dem mindestens einen drehbaren Target und dem Substrat zu einer zweiten Position (II), wobei die zweite Position für ein vorbestimmtes zweites Zeitintervall aufrechterhalten wird,
wobei mindestens eines von dem vorbestimmten ersten Zeitintervall und dem vorbestimmten zweiten Zeitintervall mindestens 1 Sekunde ist.

2. Verfahren zum Beschichten nach Anspruch 1, wobei das mindestens eine drehbare Target (120') eine Anordnung von drehbaren Targets ist.

3. Verfahren zum Beschichten nach einem der vorstehenden Ansprüche, ferner umfassend:
- Bereitstellen einer Spannung an eine Kathodenanordnung (310, 502), die dem drehbaren Target (120', 120") zugeordnet ist,
wobei das Variieren der relativen Position umfasst, die relative Position von der ersten Position zu der zweiten Position zu variieren, und die Spannung höher ist, wenn die relative Position der ersten oder der zweiten Position entspricht, als wenn die relative Position einer Position zwischen der ersten Position und der zweiten Position entspricht.

4. Verfahren zum Beschichten nach Anspruch 3, wobei die Spannung im Wesentlichen Null ist, wenn die relative Position einer Position zwischen der ersten und zweiten Position entspricht, und/oder die Spannung über die Zeit während der Variation der relativen Position gemäß einer Rechteckform variiert wird.

5. Verfahren zum Beschichten nach einem der vorstehenden Ansprüche, wobei die relative Position auf eine Weise variiert wird, sodass die Schicht aus gesputtertem Material mit einer Dickengleichmäßigkeit von mindestens ± 10 %, bevorzugt mindestens ± 5 %, noch mehr bevorzugt mindestens ± 1 % gebildet wird.

6. Verfahren zum Beschichten nach einem der vorstehenden Ansprüche, wobei das Variieren der relativen Position das Versetzen des Substrats (110) relativ zu mindestens einem drehbaren Target (120) entlang einer Ebene, die im Wesentlichen parallel zur Fläche des Substrats ist, auf dem die Schicht des gesputterten Materials gebildet wird, umfasst.

7. Verfahren zum Beschichten nach einem der vorstehenden Ansprüche, wobei das drehbare Target ein im Wesentlichen zylindrisches Target (120') ist, das um eine zylindersymmetrische Achse davon drehbar ist.

8. Verfahren zum Beschichten nach einem der vorstehenden Ansprüche, wobei die relative Position zwischen dem mindestens einen Target und dem Substrat durch Variieren des Abstandes zwischen dem mindestens einen Target und dem Substrat variiert wird.

9. Verfahren nach einem der vorstehenden Ansprüche, wobei das Sputtern eines Materials von dem mindestens einen Target (120) das Überlagern von mindestens zwei Filmverteilungen (802, 804) umfasst.

10. Verfahren nach Anspruch 9, wobei die mindestens zwei Filmverteilungen (802, 804) im Wesentlichen komplementär sind.

11. Verfahren nach Anspruch 8 oder 9, wobei das Sputtern von Material von mehreren bevorzugt drehbaren Targets (120a', 120b', 120c', 120d', 120e', 120f', 120a", 120b", 120c", 120d") ausgeführt wird, die derart angeordnet sind, dass die mindestens zwei Filmverteilungen in einer im Wesentlichen sinusförmigen Form geformt werden.

12. System zum Beschichten eines Substrats, wobei das System mindestens ein drehbares Target (120') zum Sputtern von Material auf das Substrat (110) umfasst, wobei das mindestens eine drehbare Target (120') konfiguriert ist, während der Beschichtung des Substrats (110) auf eine Weise bewegt zu werden, sodass die relative Position zwischen dem mindestens einen drehbaren Target (120) und dem Substrat (110) von einer ersten Position (I), die für ein vorbestimmtes erstes Zeitintervall aufrechterhalten wird, zu einer zweiten Position (II), die für ein vorbestimmtes zweites Zeitintervall aufrechterhalten wird, variiert wird, wobei mindestens eines von dem vorbestimmten ersten Zeitintervall und dem vorbestimmten zweiten Zeitintervall mindestens 1 Sekunde ist.

13. System zum Beschichten eines Substrats nach Anspruch 12, wobei das mindestens eine drehbare Target (120') eine Anordnung von drehbaren Targets (120a', 120b', 120c', 120d', 120e', 120f') ist.

14. System zum Beschichten eines Substrats nach Anspruch 12 oder 13, wobei das mindestens eine Target konfiguriert ist, während des Beschichtens des Substrats (110) auf eine Weise bewegt zu werden, sodass der Abstand zwischen dem mindestens einen Target (120; 120'; 120") und dem Substrat (110) variiert wird.

## Revendications

1. Procédé de revêtement d'un substrat (110), ledit procédé comprenant :
la formation d'une couche (806) de matériau pulvérisé sur ledit substrat (110), la formation de ladite couche de matériau pulvérisé comprenant :
- la pulvérisation de matériau depuis au moins une cible rotative (120') sur ledit substrat (110) ; et
- la variation de la position relative entre ladite au moins une cible rotative (120') et ledit substrat (110) jusqu'à une première position (I), laquelle première position est maintenue pendant un premier laps de temps prédéterminé ; et
- la variation de la position relative entre ladite au moins une cible rotative et ledit substrat jusqu'à une seconde position (II), laquelle seconde position est maintenue pendant un second laps de temps prédéterminé,
Sachant qu'au moins un du premier laps de temps prédéterminé et du second laps de temps prédéterminé est d'au moins 1 seconde.

2. Procédé de revêtement selon la revendication 1, dans lequel l'au moins une cible rotative (120') est un réseau de cibles rotatives.

3. Procédé de revêtement selon l'une quelconque des revendications précédentes, comprenant en outre :
- la fourniture d'une tension à un ensemble de cathodes (310,62) associé à ladite cible rotative (120', 120"),
la variation de ladite position relative incluant la variation de ladite position relative depuis ladite première position jusqu'à ladite seconde position, ladite tension étant plus élevée lorsque ladite position relative correspond à ladite première ou seconde position que lorsque ladite position relative correspond à une position entre ladite première position et ladite seconde position.

4. Procédé de revêtement selon la revendication 3, dans lequel ladite tension est substantiellement de zéro lorsque ladite position relative correspond à une position entre ladite première et ladite seconde position et/ou ladite tension est variée dans le temps en fonction d'une forme d'onde carrée pendant la variation de ladite position relative.

5. Procédé de revêtement selon l'une quelconque des revendications précédentes, dans lequel ladite position relative est variée de manière à ce que ladite couche de matériau pulvérisé soit formée en ayant une uniformité d'épaisseur d'au moins ± 10 %, de préférence d'au moins ± 5 %, et même plus préférentiellement d'au moins ± 1 %.

6. Procédé de revêtement selon l'une quelconque des revendications précédentes, dans lequel la variation de ladite position relative comprend le déplacement dudit substrat (110) par rapport à ladite au moins une cible rotative (120) le long d'un plan substantiellement parallèle à la surface du substrat sur lequel ladite couche de matériau pulvérisé est formée.

7. Procédé de revêtement selon l'une quelconque des revendications précédentes, dans lequel ladite cible rotative est une cible substantiellement cylindrique (120') pouvant tourner autour de son axe symétrique cylindrique.

8. Procédé de revêtement selon l'une quelconque des revendications précédentes, dans lequel la position relative entre ladite au moins une cible et ledit substrat est variée en variant la distance entre ladite au moins une cible et ledit substrat.

9. Procédé de revêtement selon l'une quelconque des revendications précédentes, dans lequel la pulvérisation d'un matériau depuis l'au moins une cible (120) inclut la superposition d'au moins deux distributions de films (802,804).

10. Procédé de revêtement selon la revendication 9, dans lequel lesdites au moins deux distributions de films (802,804) sont substantiellement complémentaires.

11. Procédé de revêtement selon la revendication 8 ou 9, dans lequel la pulvérisation de matériau est réalisée depuis une pluralité de cibles de préférence rotatives (120a', 120b', 120c', 120d', 120e', 120f', 120a", 120b", 120c", 120d") disposées de manière à ce que lesdites au moins deux distributions de films (802,804) soient modelées en une forme substantiellement sinusoïdale.

12. Système de revêtement d'un substrat, ledit système comprenant au moins une cible rotative (120') pour pulvériser du matériau sur ledit substrat (110), ladite au moins une cible rotative (120') étant configurée pour être déplacée pendant le revêtement dudit substrat (110) de manière à ce que la position relative entre ladite au moins une cible rotative (120) et ledit substrat (110) soit variée depuis une première position (I), laquelle première position est maintenue pendant un premier laps de temps prédéterminé jusqu'à une seconde position (II), laquelle seconde position est maintenue pendant un second laps de temps prédéterminé, sachant qu'au moins un du premier laps de temps prédéterminé et du second laps de temps prédéterminé est d'au moins 1 seconde.

13. Système de revêtement d'un substrat selon la revendication 12, dans lequel l'au moins une cible rotative (120') est un réseau de cibles rotatives (120a', 120b', 120c', 120d', 120e', 120f').

14. Système de revêtement d'un substrat selon la revendication 12 ou 13, dans lequel l'au moins une cible rotative est configurée pour être déplacée pendant le revêtement dudit substrat (10) de manière à ce que la distance entre ladite au moins une cible (120 ; 120' ; 120") et ledit substrat (110) soit variée.
